(19) Europäisches Patentamt
European Patent Office
Office européen des brevets

(11) **EP 4 209 561 A1**

(12) **EUROPEAN PATENT APPLICATION**
published in accordance with Art. 153(4) EPC

(43) Date of publication:
**12.07.2023 Bulletin 2023/28**

(21) Application number: **21864300.5**

(22) Date of filing: **31.08.2021**

(51) International Patent Classification (IPC):
*C09G 1/02* (2006.01)    *C09K 3/14* (2006.01)
*B24B 37/00* (2012.01)    *H01L 21/304* (2006.01)
*C01F 17/235* (2020.01)

(52) Cooperative Patent Classification (CPC):
**B24B 37/00; C01F 17/235; C09G 1/02; C09K 3/14; H01L 21/304**

(86) International application number:
**PCT/JP2021/031821**

(87) International publication number:
**WO 2022/050242 (10.03.2022 Gazette 2022/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **04.09.2020   JP 2020148694**

(71) Applicant: **AGC INC.**
**Chiyoda-ku,**
**Tokyo 1008405 (JP)**

(72) Inventors:
• **SHIBUYA Tomohiro**
**Tokyo 100-8405 (JP)**
• **OKAMURA Yuzo**
**Tokyo 100-8405 (JP)**

(74) Representative: **Müller-Boré & Partner**
**Patentanwälte PartG mbB**
**Friedenheimer Brücke 21**
**80639 München (DE)**

(54) **CERIUM OXIDE AND POLISHING AGENT**

(57)    Provided are a cerium oxide capable of high-speed polishing on a silicon nitride film and a polishing agent containing such a cerium oxide. The cerium oxide has a BET diameter of no smaller than 15 nm nor greater than 100 nm, the BET diameter being a particle size calculated from a specific surface area measured through a nitrogen gas adsorption method; a Scherrer diameter of no smaller than 10 nm nor greater than 50 nm, the Scherrer diameter being a crystallite diameter obtained through a powder X-ray diffraction method; and a value obtained by dividing the BET diameter by the Scherrer diameter of no smaller than 1.4 nor greater than 3.5. The polishing agent includes this cerium oxide and water.

Fig. 1B

## Description

### Technical Field

The present invention relates to cerium oxides and polishing agents.

### Background Art

The recent trend toward a higher degree of integration or higher functionality of semiconductor integrated circuits is propelling development in microfabrication techniques that achieve smaller, denser semiconductor elements. Conventionally, in the manufacture of semiconductor integrated circuit devices (referred to below also as semiconductor devices), interlayer insulating films, buried wirings, or the like are flattened with use of chemical mechanical polishing (hereinafter, CMP) so as to prevent such problems as that sufficient resolution cannot be obtained as the unevenness (steps) in a layer surface exceeds the depth of focus in lithography. Importance of further flattening with use of CMP is on the rise as the demands for higher-definition, smaller elements become severer.

Furthermore, in the manufacture of semiconductor devices in recent years, a method of isolation with a shallow trench with a small element isolation width (Shallow Trench Isolation: hereinafter, STI) is adopted in order to advance even higher shrinkage of semiconductor elements.

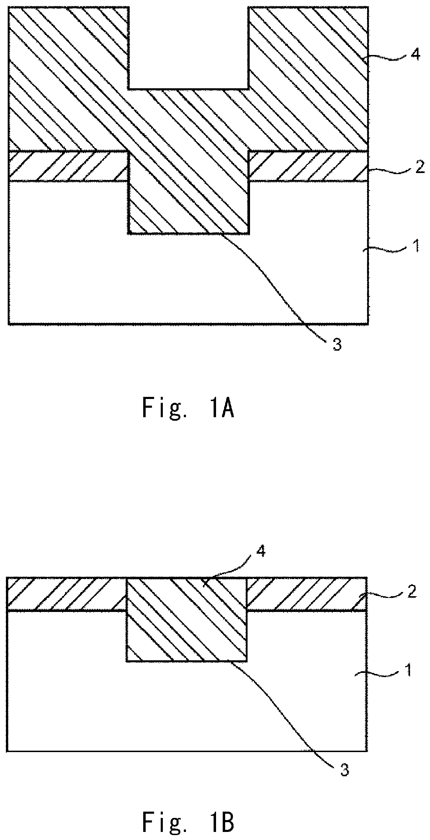

In this technique called STI, a trench (groove) is formed in a silicon substrate, and the trench is filled with an insulating film. Thus, element regions that are electrically insulated are formed. One example of STI will be described with reference to Figs. 1A and 1B. As illustrated in FIG. 1A, an element region of a silicon substrate 1 is masked with a silicon nitride film 2 or the like. Then, a trench 3 is formed in the silicon substrate 1, and an insulating layer, such as a silicon dioxide film 4, is deposited to fill the trench 3. Next, the silicon dioxide film 4 on the silicon nitride film 2, which defines a protruding portion, is polished to be removed through CMP, with the silicon dioxide film 4 in the trench 3, which defines a recessed portion, remaining. Thus, an element isolation structure in which the trench 3 is filled with the silicon dioxide film 4, as illustrated in Fig. 1B, is obtained.

Polishing agents that contain cerium oxide particles are known as a type of polishing agents for CMP.

Patent Literature 1, for example, discloses a polishing agent that contains a specific water-soluble polymer, cerium oxide particles, and water and that has a pH of 4-9. With this polishing agent disclosed in Patent Literature 1, the polishing speed on a silicon nitride film can be kept low while maintaining a high polishing speed on a silicon oxide film. In the example shown in Figs. 1A and 1B, the silicon nitride film 2 serves as a polishing stopper film, and thus a favorable flat surface can be obtained.

Separately from the above, Patent Literature 2 discloses, as a method of preparing a metal-doped cerium composition that excels in thermal stability and is used in, for example, a catalyst for processing exhaust gas, a specific method that includes, in the presence of nitric acid ions, preparing a solution containing a cerium (III) salt, cerium (IV), and a salt of a metal; forming a precipitate by bringing this solution into contact with a base; and subjecting this precipitate to heat treatment.

Patent Literature 1 further discloses a nitrogen gas adsorption method, which will be described later.

### Citation list

### Patent Literature

Patent Literature 1: Japanese Unexamined Patent Application Publication No. 2019-87660
Patent Literature 2: Japanese Unexamined Patent Application Publication No. 2017-529296

### Non Patent Literature

Non Patent Literature 1: Brunauer, S., Emmett, P. T., and Teller, E.: Adsorption Gases in Multimolecular Layers, J. Amer. Che. Soc., Vol.60, No. 2, pp. 309-319, 1938.

### Summary of Invention

### Technical Problem

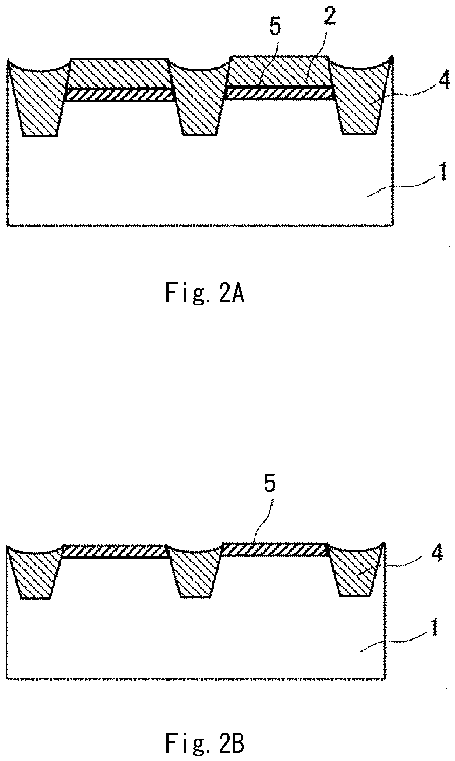

Another example of STI separate from the one shown in Figs. 1A and 1B will be described with reference to Figs. 2A and 2B. As illustrated in Fig. 2A, this example differs from the one shown in Fig. 1A in that a titanium nitride film 5 and a silicon nitride film 2 are stacked in this order over an element region of a silicon substrate 1. In the example shown in Fig. 2A, the silicon nitride film 2, along with a silicon oxide film 4, needs to be polished to be removed.

In this respect, a typical use of conventional polishing agents containing cerium oxide particles is to polish a silicon oxide film at a high speed and to keep the polishing speed on a silicon nitride film low, and such conventional polishing agents are not to polish a silicon oxide film and a silicon nitride film simultaneously at a high speed.

In one conceivable method, an additive that works on a silicon oxide film of a high polishing speed may be added, and thus polishing of the silicon oxide film can be slowed to equalize the speeds. However, such a method poses a problem that faster polishing processes are hindered.

In CMP, there is a demand for a polishing agent capable of high-speed polishing on a silicon nitride film so as to polish a silicon oxide film and a silicon nitride film at the same speed while maintaining a sufficiently high polishing speed.

The present invention has been made in view of such circumstances and is directed to providing a cerium oxide capable of high-speed polishing on a silicon nitride film and a polishing agent containing such a cerium oxide.

**Solution to Problem**

A first embodiment of a cerium oxide according to the present invention has: a BET diameter of no smaller than 15 nm nor greater than 100 nm, the BET diameter being a particle size calculated from a specific surface area measured through a nitrogen gas adsorption method; a Scherrer diameter of no smaller than 10 nm nor greater than 50 nm, the Scherrer diameter being a crystallite diameter obtained through a powder X-ray diffraction method; and a value obtained by dividing the BET diameter by the Scherrer diameter of no smaller than 1.4 nor greater than 3.5.

A second embodiment of a cerium oxide according to the present invention is a particle having a true density of 5.0-6.8 g/cm$^3$.

The above cerium oxide may include one or more metals selected from the group consisting of an alkaline-earth metal and a lanthanoid (excluding cerium).

The above cerium oxide may include the metal in 1-20 mol%.

In the above cerium oxide, the lanthanoid may include lanthanum.

In the above cerium oxide, the alkaline-earth metal may include one or more selected from the group consisting of barium and strontium.

The above cerium oxide may have a value obtained by subtracting a lattice constant of a cerium oxide that does not include the metal from a lattice constant of a cerium oxide that includes the metal of 0.003-0.05 Å.

The present invention provides a polishing agent that includes the above cerium oxide and water.

**Advantageous Effects of Invention**

The present invention provides a cerium oxide capable of high-speed polishing on a silicon nitride film and a polishing agent containing such a cerium oxide.

**Brief Description of Drawings**

Fig. 1A is a sectional view illustrating one example of a semiconductor substrate to be polished through CMP in STI, taken before polishing;
Fig. 1B is a sectional view illustrating one example of a semiconductor substrate to be polished through CMP in STI, taken after polishing;
Fig. 2A is a sectional view illustrating another example of a semiconductor substrate;
Fig. 2B is a sectional view illustrating one example of the semiconductor substrate illustrated in Fig. 2A, taken after polishing; and
Fig. 3 is a schematic diagram illustrating one example of a polishing apparatus.

**Description of Embodiments**

Some embodiments of the present invention will be described below. The present invention is not limited to the following embodiments, and any other embodiments may belong to the scope of the present invention as long as such embodiments match the spirit of the present invention.

The term "surface to be polished" as used according to the present invention refers to the surface of a polishing target that is to be polished and means, for example, an outer surface. In the present description, an intermediate-step surface that appears on a semiconductor substrate in the process of manufacturing a semiconductor device is also encompassed by the "surface to be polished."

"Silicon oxide" as used according to the present invention is specifically silicon dioxide. "Silicon oxide," however, is not limited to silicon dioxide and also includes any silicon oxides other than silicon dioxide.

The term "selection ratio" as used according to the present invention refers to the ratio ($R_{SiO2}/R_{SiN}$) of the polishing speed ($R_{SiO2}$) on a silicon oxide film to the polishing speed ($R_{SiN}$) on a silicon nitride film.

The symbol "-" indicating a numerical range means that the range includes the numerical values preceding and following the symbol as the lower limit and the upper limit.

[BET Diameter and Scherrer Diameter]

First, a BET diameter and a Scherrer diameter that identify a cerium oxide according to a first embodiment will be described.

The BET diameter is a value calculated through the following equation (1), with a particle assumed to be spherical, from the specific surface area that is measured through a specific surface area measurement, calculated from a nitrogen gas adsorption volume obtained in a nitrogen gas adsorption method and a Brunauer-Emmett-Teller equation (BET equation).

$$d_B = 6/\rho s \quad \text{Equation (1)}$$

In the above, $d_B$ is the particle size (BET diameter), $\rho$ is the density of the cerium oxide, and s is the specific surface area.

The nitrogen gas adsorption method according to the present invention employs a BET fluid process (single-point method), with reference to Non Patent Literature 1. The cerium oxide to be measured is pretreated at 200°C for 20 minutes to remove any substance adsorbed thereon. Then, a nitrogen gas isothermal adsorption curve of this cerium oxide is measured, and the specific surface area is calculated from this isothermal adsorption curve with use of the BET equation (Equation (2) below). The isothermal adsorption curve can be measured with use of a fully automatic specific surface area measuring apparatus (manufactured by Mountech Co., Ltd., (product name) Macsorb, or the like.).

[Math. 1]

$$\frac{P}{V(Po-P)} = \frac{1}{VmC} + \frac{C-1}{VmC} \times \frac{P}{Po} \quad \text{Equation (2)}$$

In the above, Vm is a monomolecular layer adsorption amount of nitrogen gas (the volume of nitrogen gas adsorbed on a first layer), V is the volume of adsorbed nitrogen gas, P is the pressure within the sample, Po is the saturated vapor pressure, and C is a constant related to heat of adsorption or the like.

When P/Po is plotted on the horizontal axis and P/V(Po - P) is plotted on the vertical axis, a straight line (BET plot) is obtained. Vm is obtained from the intercept and the slope of this straight line, and the BET specific surface area s is calculated through the following equation (3).

$$s = Vm \times N \times Am$$

In the above, N is the Avogadro's number, Am is the area (0.162 nm) occupied by one molecule of nitrogen gas, and s and Vm are as described above.

The Scherrer diameter is a value calculated through the Scherrer equation (Equation (4) below) from the linewidth or the like of a powder X-ray diffraction peak.

$$d_S = K\lambda/\beta\cos\theta \quad \text{Equation (4)}$$

In the above, ds is the crystallite diameter (Scherrer diameter), K is the Scherrer constant, $\lambda$ is the wavelength of the X-ray, $\theta$ is the Bragg angle, and $\beta$ is the full width at half maximum.

According to the present invention, the Scherrer diameter is obtained from a half width of a peak on 111 plane diffraction near 28.5°, which is a main peak of cerium oxide.

The cerium oxide according to the first embodiment has a BET diameter of no smaller than 14 nm nor greater than 210 nm, the BET diameter being a particle size calculated from the specific surface area measured through the nitrogen gas adsorption method; a Scherrer diameter of no smaller than 10 nm nor greater than 60 nm, the Scherrer diameter being a crystallite diameter obtained through a powder X-ray diffraction method; and a value ($d_B/d_S$) obtained by dividing the BET diameter $d_B$ by the Scherrer diameter ds of no smaller than 1.4 nor greater than 3.5.

A polishing agent that includes this cerium oxide in the form of abrasive grains has a high polishing speed on a silicon nitride film, and this, for example, makes it possible to polish a silicon oxide film and a silicon nitride film at the same speed while maintaining a sufficiently high polishing speed.

Although the mechanism that makes the above cerium oxide excel in polishability on a silicon nitride film is not yet fully understood, the following can be speculated.

The present cerium oxide particles are present in the form of an aggregate particle (secondary particle) in the polishing agent.

Such an aggregate particle is predicted to have a smaller measured BET diameter than a non-aggregate cerium oxide particle. In other words, $d_B/d_S$ is estimated to take a value reflective of the aggregate state of the cerium oxide particles.

It is estimated that cerium oxide particles having $d_B/d_S$ of no smaller than 1.4 nor greater than 3.5 excel in the balance between the particle size and the ratio of the surface that chemically interacts with silicon nitride, and as a result, the polishing speed on a silicon nitride film improves while suppressing an occurrence of polish scratches on a silicon nitride film or a silicon oxide film.

The lower limit value of $d_B/d_S$ is preferably no smaller than 1.5, more preferably no smaller than 1.6, even more preferably no smaller than 1.7, or particularly preferably no smaller than 2.0. The upper limit value of $d_B/d_S$ is preferably no greater than 3.5 or more preferably no greater than 3.0.

[True Density]

Next, the true density that identifies a cerium oxide according to a second embodiment will be described.

A density encompasses a true density, an apparent density, a bulk density, and so on. The true density is defined as a density in which the volume of a substance alone serves as a volume for calculating the density. Known methods of measuring the true density include a liquid displacement method and a gas displacement method. The apparent density is defined as a density in which the volume of a substance and any air gap inside the substance serves as a volume for calculating the density. In reality, in addition to the above, the volume of a space in a rugged portion on the surface of a particle that is not wetted by liquid is also included in the volume for calculating the density. Known methods of measuring the apparent density include the Le Chatelier flask method, the buoyancy weighing method, the Archimedes' method, or the mercury porosimetry. The bulk density is defined as a density in which a volume of a substance, any air gap inside the substance, and fine apertures serves as a volume for calculating the density. In reality, in addition to the above, the volume of a space in a rugged portion on the surface of a particle, a volume of any air gap between particles, and a volume of any air gap between a particle and a receptacle are also included in the volume for calculating the density. Known methods of measuring the bulk density include a container method and a funnel method.

For the cerium oxide according to the second embodiment, the true density is used as the density. According to the present invention, the true density is measured through a gas displacement method. A gaseous phase displacement method can be considered to be the optimal method for measuring the density of an aggregate of particles having a size of several tens of nanometers, because as gas serves as a probe in the gaseous phase displacement method, as oppose to a liquid phase displacement method in which liquid serves as a probe, a tiny space between particles or in an aperture in the surface of a particle, such as a closed pore, can be more easily reflected on the volume for measuring the density.

The density of the cerium oxide according to the second embodiment has a density measured through a gaseous phase displacement method with He serving as a probe of, that is, a true density of preferably no smaller than 5.0 g/cm$^3$ nor greater than 6.8 g/cm$^3$. In particular, the true density is preferably no smaller than 5.5 g/cm$^3$ nor greater than 6.7 g/cm$^3$ or more preferably no smaller than 6.0 g/cm$^3$ nor greater than 6.6 g/cm$^3$. When the true density is no greater than 6.8 g/cm$^3$, even when a hard film, such as a silicon nitride film, is polished at a high speed, any scratches produced in the silicon nitride film can be minimized. As the true density is no smaller than 5.0 g/cm$^3$, scratches produced in a silicon oxide film or the like can be minimized while maintaining a desired polishing rate on the silicon oxide film.

The value of the true density of the cerium oxide according to the second embodiment is much smaller than 7.215 g/cm$^3$, the documented value of the density of cerium oxide. Estimated main factors that can keep the true density of the present cerium oxide much lower include (1) a lattice defect, that is, an oxygen vacancy; and (2) a difference in the atomic weight resulting from the replacement of a metallic element different from cerium. Since the true density of the present cerium oxide is even lower than the theoretical value that takes both (1) and (2) into consideration, the presence of other factors can be speculated.

[Lattice Constant]

Next, a lattice constant (a) that identifies the cerium oxide will be described.

According to the present invention, the lattice constant is determined by a pattern obtained through X-ray diffraction and an assigned Miller index (hkl). The following can be determined based on a value ($\Delta a = a_1 - a_0$) obtained by subtracting a lattice constant ($a_0$) of a cerium oxide that does not contain metal from a lattice constant ($a_1$) of a cerium oxide that contains metal. Specifically, when the value of $\Delta a$ is positive, this indicates that an ion having a radius greater than the ionic radius of a cerium ion is incorporated into the lattice of the cerium oxide, and thus the lattice has extended. Meanwhile, when the value of $\Delta a$ is negative, this indicates that an ion having a radius smaller than the ionic radius of a cerium ion is incorporated into the lattice of the cerium oxide, and thus the lattice has contracted. Moreover, as the absolute value of $\Delta a$ is greater, this means that an ion having a radius far from the ionic radius of a cerium ion is incorporated into the lattice or that a large amount of ions are incorporated into the lattice. In this manner, how different elements are incorporated into the lattice can be determined based on $\Delta a$.

$\Delta a$ is preferably 0.003-0.05 Å or more preferably 0.004-0.03 Å. When $\Delta a$ is within these ranges, a high polishing speed on a silicon nitride film can be obtained.

The cerium oxide according to the present invention may be a cerium oxide that satisfies both the definition according to the foregoing first embodiment and the definition according to the second embodiment. In other words, the present cerium oxide is preferably a particle having a BET diameter $d_B$ of no smaller than 14 nm nor greater than 210 nm, a Scherrer diameter ds of no smaller than 10 nm nor greater than 60 nm, $d_B/d_S$ of no smaller than 1.4 nor greater than 3.5, and a true density of 5.0-6.8 g/cm$^3$.

A preferred embodiment of and a preferred method of manufacturing a cerium oxide will be described below. Unless specifically indicated otherwise, the following description applies to both the cerium oxide according to the first embodiment and the cerium oxide according to the second embodiment.

The present cerium oxide may be composed of cerium and oxygen and may further include other atoms. From the standpoint of ease of adjusting the BET diameter, the Scherrer diameter, and the true density described above to specific ranges, and from the standpoint of ease of adjusting $\Delta a$ described above to the aforementioned range, the present cerium oxide preferably includes a metal selected from an alkaline-earth metal and a lanthanoid excluding cerium.

Examples of such an alkaline-earth metal include beryllium, magnesium, calcium, strontium, barium, and radium, and from the standpoint of polishability of silicon nitride, strontium or barium is preferable.

Examples of a lanthanoid include lanthanum, praseodymium, neodymium, promethium, samarium, europium, gadolinium, terbium, dysprosium, holmium, erbium, thulium, ytterbium, and lutetium, and from the standpoint of polishability of silicon nitride, lanthanum is preferable.

These metals may each be used singly, or two or more of these metals may be used in combination.

In the present cerium oxide, the content ratio of the above metal is preferably 1-20 mol% with respect to the total amount of the present cerium oxide including the metal and so on, or more preferably 1-18 mol%.

The present cerium oxide may further include other atoms within a range that can still provide the advantageous effects of the present invention. Examples of such atoms include fluorine, carbon, nitrogen, aluminum, and silicon. From the standpoint of polishability of silicon nitride, these other atoms are contained preferably in no greater than 5 mol% or more preferably in no greater than 1 mol% with respect to the total amount of the cerium oxide.

In particular, fluorine atoms may increase the hardness of the cerium oxide to scratch the polishing surface, and thus the content ratio of fluorine atoms is preferably no greater than 1 mol% or more preferably no greater than 0.1 mol% with respect to the total amount of the cerium oxide.

Although there is no particular limitation on the crystal structure of the cerium oxide, from the standpoint of polishability, a cubic fluorite structure is preferable. According to the manufacturing method described below, a cerium oxide having a cubic fluorite structure can be obtained.

[Method of Manufacturing Cerium Oxide]

For the method of manufacturing the present cerium oxide, a desired method can be selected from a method that yields a cerium oxide having a BET diameter $d_B$ of no smaller than 14 nm nor greater than 210 nm, a Scherrer diameter ds of no smaller than 10 nm nor greater than 60 nm, and $d_B/d_S$ of no smaller than 1.4 nor greater than 3.5, and a method that yields a cerium oxide having a true density of 5.0-6.8 g/cm$^3$. As one example of such manufacturing methods, a manufacturing method that includes the following steps 1 to 3 (also referred to below as the present manufacturing method) can be illustrated.

The present manufacturing method includes the following steps 1 to 3.

Step 1: A step of adding an aqueous solution containing a dopant that includes one or more metals selected from the group consisting of an alkaline-earth metal and a lanthanoid (excluding cerium) to a slurry in which a compound containing poorly soluble cerium is dispersed.
Step 2: A step of drying the slurry and causing the dopant to adhere to the surface of the compound containing the cerium.
Step 3: A step of calcining the compound containing the cerium to which the dopant has adhered.

With the present manufacturing method, the cerium oxide can be synthesized favorably. Each of the steps will be described below.

In the present manufacturing method, first, each of a slurry in which a compound containing poorly soluble cerium is dispersed and an aqueous solution containing a dopant that includes one or more metals selected from the group consisting of an alkaline-earth metal and a lanthanoid is prepared.

Examples of poorly soluble cerium include cerium oxide, cerium carbonate, cerium hydroxide, cerium sulfate, cerium phosphate, cerium oxalate, and cerium carbonate hydroxide. A dispersion medium for poorly soluble cerium is normally water.

The aqueous solution is an aqueous solution in which the specific metal is dissolved. Examples of a water-soluble compound containing the metal include a nitrate, a carbonate, an acetate, a sulfate, an oxalate, a chloride, a hydroxide, and a halide. The aqueous solution may have its pH or the like adjusted. For example, even a compound that is poorly soluble in water, such as an oxide, can also be used if that compound becomes soluble upon its pH or the like adjusted. Among the above, a compound that is highly soluble in water is preferable in the manufacturing process, and a compound in which a counteranion of a metallic element dissolves or volatilizes at low temperature is preferable from the standpoint of stability of polishing characteristics, in particular, of the polishing rate. Examples of compounds that satisfy such characteristics include an oxalate and an acetate. An aqueous solution in which, for example, a carbonate and an organic acid are dissolved or an aqueous solution in which a hydroxide and an organic acid are dissolved is also suitable.

After the slurry and the aqueous solution have been prepared, the aqueous solution is added to the slurry. The aqueous solution may be added at room temperature or at an elevated temperature.

Next, the slurry is dried. Any desired drying method can be selected from methods for evaporating moisture. For example, the slurry may be heated with a heater or in a furnace, heated in a warm bath, or sprayed with dry air. From the standpoint of causing the dopant to adhere uniformly onto the surface of the compound containing the cerium, the slurry is preferably stirred during the drying step. The slurry is dried in the present drying step.

The compound that contains the cerium and to which the dried dopant has adhered is pulverized, as necessary, and heated and calcined. From the standpoint of crystallinity, the heating temperature is preferably no lower than 500°C, more preferably no lower than 600°C, or even more preferably no lower than 700°C. Meanwhile, although there is no particular limitation on the upper limit of the heating temperature, the heating temperature is normally no higher than 1000°C, and from the standpoint of suppressing an increase in the coarse particles, the heating temperature is preferably no higher than 950°C or more preferably no higher than 900°C.

Herein, in a case where a large amount of Sr or Ba is used as an alkaline-earth metal, the obtained cerium oxide may contain, as an impurity, strontium carbonate or barium carbonate. In this case, the carbonate can be removed by washing the cerium oxide with an aqueous acid solution whose pH has been adjusted to around 2 with a hydrochloric acid or a nitric acid aqueous solution, as necessary.

The manufacturing method described above provides a cerium oxide particle having a BET diameter of no smaller than 14 nm nor greater than 210 nm, the BET diameter being a particle size calculated from the specific surface area measured through a nitrogen gas adsorption method; a Scherrer diameter of no smaller than 10 nm nor greater than 60 nm, the Scherrer diameter being a crystallite diameter obtained through a powder X-ray diffraction method; a value obtained by dividing the BET diameter by the Scherrer diameter of no smaller than 1.4 nor greater than 3.5; a true density of 5.0-6.8 g/cm$^3$; and a value ($\Delta$a) obtained by subtracting the lattice constant of a cerium oxide that does not include metal from the lattice constant of a cerium oxide that includes metal of 0.003-0.05 Å.

<Use of Cerium Oxide>

The present cerium oxide can be used suitably as abrasive grains in a polishing agent for use, for example, in CMP, or in particular in STI. Since the present cerium oxide helps improve the polishing speed on a silicon nitride surface, in particular in CMP of a surface to be polished including a silicon oxide surface and a silicon nitride surface, the silicon oxide surface and the silicon nitride surface can be polished at the same speed while a decrease in the polishing speed is suppressed.

When the present cerium oxide is used as a polishing agent, the present cerium oxide is preferably used with the particles of the present cerium oxide dispersed in a dispersion medium. The dispersion medium may be selected, as appropriate, from liquid in which the present cerium oxide is insoluble or poorly soluble. In use in CMP, water is in particular preferable as a dispersion medium. A polishing agent containing the present cerium oxide may contain a known additive, as appropriate and as necessary.

There is no particular limitation on such an additive, and examples of the additive include a polymer, a pH regulator, and a chelating agent that adjust the polishing rate on a silicon oxide film or a silicon nitride film.

As the pH regulator, any one selected, as appropriate, from known inorganic acids, organic acids, basic compounds, amphoteric compounds such as amino acids, and salts thereof can be used.

Examples of the inorganic acids include a nitric acid, a sulfuric acid, a hydrochloric acid, and a phosphoric acid, and an ammonium salt, a sodium salt, a potassium salt, or the like thereof may be used.

Examples of the organic acids include carboxylic acids such as a picolinic acid, organic sulfonic acids, and organic phosphoric acids, and an ammonium salt, a sodium salt, a potassium salt, or the like thereof may be used. Examples of the organic basic compounds include, as basic compounds, compounds containing nitrogen, such as ammonia, potassium hydroxide, tetramethylammonium hydroxide, or ethylene diamine.

Examples of the amphoteric compounds include glycine, alanine, and phenylalanine.

For the chelating agent, any chelating agent can be selected, as appropriate, from those known to be used for polishing agents, and examples include a dicarboxylic acid-based chelating agent, a tricarboxylic acid-based chelating agent, a gluconic acid-based chelating agent, a nitrilotriacetic acid-based chelating agent, and an iminosuccinic acid-based chelating agent.

Examples of a method of polishing with use of a polishing agent containing the present cerium oxide include a method in which a polishing pad is bought into contact with a surface to be polished of a polishing target while the polishing agent is supplied, and the surface to be polished is polished through the relative motion of the surface to be polished and the polishing pad. Herein, examples of the surface to be polished include a surface of a semiconductor substrate on which a silicon oxide film and silicon nitride are arranged in a pattern.

When a silicon nitride film is polished with use of a polishing agent containing the present cerium oxide, it is preferable that a titanium nitride film, a polysilicon film, or the like be provided as a base film. Since the present cerium oxide has a low polishing rate on such a base film, a flattened surface where the base film is exposed to the surface is formed.

Examples of a silicon dioxide film in an STI substrate include what is known as a PE-TEOS film, which is deposited through a plasma CVD technique with a tetraethoxysilane (TEOS) serving as a source material. Other examples of a silicon dioxide film include what is known as an HDP film, which is deposited through a high-density plasma CVD technique. A HARP film or an FCVD film deposited through other CVD techniques or a SOD film formed through spin coating can also be used. Examples of a silicon nitride film include a film deposited through a low-pressure CVD technique or a plasma CVD or a film deposited through an ALD technique, with silane or dichlorosilane and ammonia serving as source materials.

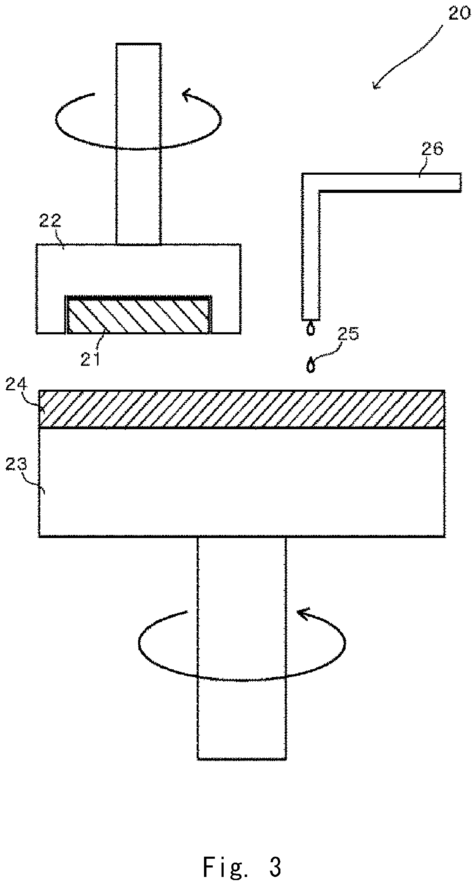

Any known polishing apparatus can be used in the polishing method according to an embodiment of the present invention. Fig. 3 is a schematic diagram illustrating one example of a polishing apparatus. A polishing apparatus 20 of the example shown in Fig. 3 includes a polishing head 22 that holds a semiconductor substrate 21, such as an STI substrate; a polishing platen 23; a polishing pad 24 affixed to a surface of the polishing platen 23; and a polishing agent feeding pipe 26 that feeds a polishing agent 25 to the polishing pad 24. While the polishing agent 25 is fed from the polishing agent feeding pipe 26, a surface to be polished of the semiconductor substrate 21 held by the polishing head 22 is brought into contact with the polishing pad 24, and the surface to be polished is polished with the polishing head 22 and the polishing platen 23 each undergo a rotary motion relative to each other.

The polishing head 22 may undergo not only the rotary motion but also a linear motion. The polishing platen 23 and the polishing pad 24 may have a size equivalent to or smaller than the size of the semiconductor substrate 21. In this case, it is preferable that the polishing head 22 and the polishing platen 23 be moved relative to each other, so that the entire surface of the surface to be polished of the semiconductor substrate 21 can be polished. The polishing platen 23 and the polishing pad 24 need not undergo a rotary motion and may move along one direction, for example, with a belt-like system.

Although there is no particular limitation on the polishing condition of such a polishing apparatus 20, if a load is exerted on the polishing head 22 to press the polishing head 22 against the polishing pad 24, the polishing pressure can be increased, and the polishing speed can thus be improved. The polishing pressure is preferably about 0.5-50 kPa, or is more preferably about 3-40 kPa from the standpoint of uniformity and flatness of the polishing speed within the surface to be polished of the semiconductor substrate 21 and from the standpoint of prevention of any polishing defect caused by a scratch or the like. The number of rotations of the polishing platen 23 and the polishing head 22 is preferably about 50-500 rpm. The feeding amount of the polishing agent 25 is adjusted, as appropriate, based on the composition of the polishing agent or the polishing condition or the like described above.

For the polishing pad 24, a polishing pad made of nonwoven fabric, polyurethane foam, porous resin, nonporous resin, or the like can be used. In order to facilitate the feeding of the polishing agent 25 to the polishing pad 24 or in order to pool a certain amount of the polishing agent 25 in the polishing pad 24, the surface of the polishing pad 24 may be grooved in a lattice pattern, in a concentric circular pattern, or in a spiral pattern. The polishing may be performed, as necessary, with a pad conditioner in contact with the surface of the polishing pad 24 and while the surface of the polishing pad 24 is conditioned.

**Examples**

The present invention will be described in more concrete terms with examples and comparative examples below, but the present invention is not limited by these examples. In the following examples, "%" means mass% unless specifically indicated otherwise. The characteristic values were measured and evaluated through the method described below. Examples 1 to 4 are examples of cerium oxides according to the present invention and methods of manufacturing the same, and Examples 5 to 7 are comparative examples.

[Synthesis of Cerium Oxide]

(Example 1)

42.4 g of anhydride of cerium carbonate was changed into a firing furnace and calcined for 1 hour while air was blown into the firing furnace at 800°C. A slurry containing 31.7 g of powder of a cerium oxide obtained as described above was placed in an evaporating dish. Next, 8.834 g of lanthanum nitrate hexahydrate was dissolved in 40 mL of pure water. The evaporating dish having the slurry placed therein was placed on a hot stirrer, and the slurry was stirred with a stirrer with the temperature set at 200°C. Upon confirming that vapors started to arise from the evaporating dish, an aqueous solution of lanthanum nitrate was added bit by bit over about 3 minutes, and the slurry was completely dried while being stirred. The precursor in a mass form was pulverized in an agate mortar to a powder form, and this was calcined in an electric furnace. The calcining temperature was 800°C, and the calcining duration was 8 hours. The temperature was raised to 800°C over 2 hours, and the temperature was lowered through natural dissipation after the calcining. The obtained powder was pulverized in an agate mortar and washed with 300 mL of pure water. With use of a 0.1-$\mu$m membrane filter and a suction filtration device, the above resultant was washed with pure water until the pH of the filtrate approaches being neutral, and particles were collected. The collected particles were dried for 12 hours in a thermostatic bath at 80°C, and the moisture was removed completely. The obtained powder was again pulverized in an agate mortar, and the cerium oxide of Example 1 was obtained.

(Example 2)

The cerium oxide of Example 2 was obtained in a manner similar to that of Example 1, except that 4.317 g of strontium nitrate was used in place of lanthanum nitrate hexahydrate of Example 1.

(Example 3)

The cerium oxide of Example 3 was obtained in a manner similar to that of Example 1, except that 2.665 g of strontium nitrate was used in place of lanthanum nitrate hexahydrate of Example 1.

(Example 4)

The cerium oxide of Example 4 was obtained in a manner similar to that of Example 1, except that 5.331 g of barium nitrate was used in place of lanthanum nitrate hexahydrate of Example 1.

(Example 5)

42.4 g of anhydride of cerium carbonate was changed into a firing furnace and calcined for 1 hour while air was blown into the firing furnace at 800°C. A slurry containing 31.7 g of powder of a cerium oxide obtained as described above was placed in an evaporating dish. The evaporating dish having the slurry placed therein was placed on a hot stirrer, and the slurry was dried completely while being stirred with a stirrer with the temperature set at 200°C. The precursor in a mass form was pulverized in an agate mortar to a powder form, and this was calcined in an electric furnace. The calcining temperature was 800°C, and the calcining duration was 8 hours. The temperature was raised to 800°C over 2 hours, and the temperature was lowered through natural dissipation after the calcining. The obtained powder was pulverized in an agate mortar and washed with 300 mL of pure water. With use of a 0.1-$\mu$m membrane filter and a suction filtration device, the above resultant was washed with pure water until the pH of the filtrate approaches being neutral, and particles were collected.

The collected particles were dried for 12 hours in a thermostatic bath at 80°C, and the moisture was removed completely.

The obtained powder was again pulverized in an agate mortar, and the cerium oxide of Example 5 was obtained.

(Example 6)

The cerium oxide of Example 6 was obtained in a manner similar to that of Example 1, except that 4.35 g of aluminum nitrate was used in place of lanthanum nitrate hexahydrate of Example 1.

(Example 7)

The cerium oxide of Example 7 was obtained in a manner similar to that of Example 1, except that 0.188 g of potassium nitrate was used in place of lanthanum nitrate hexahydrate of Example 1.

[BET Diameter and Scherrer Diameter]

The BET diameter and the Scherrer diameter of each of the cerium oxides obtained in Examples 1 to 7 were calculated through the equations (1) to (4) described above.

The specific surface area was measured and evaluated with use of Macsorb manufactured by Mountech Co., Ltd. and through a BET fluid process (single-point method), which is one of the physical adsorption processes. As pretreatment of the samples, each sample was treated for 20 minutes at 200 degrees, and any substance adsorbed on the surface of the sample was removed in advance. Pure nitrogen was used as a gas.

The X-ray diffraction (XRD) was measured and evaluated with use of a high-speed X-ray diffractometer Smart-Lab manufactured by Rigaku Corporation. The measurement conditions were set as follows. X-ray tube: Cu, voltage: 40 kV, current: 200 mA, scan mode: Step Scan, measurement angle range: 10-150 degrees, sampling interval: 0.01 degrees, and scan duration per step: 2 s. Each obtained XRD profile was compared against a database (JCPDS No.: 34-0394) to confirm that a cerium oxide having a target cubic fluorite structure was obtained.

[True Density]

The true density of each of the cerium oxides obtained in Examples 1 to 7 was measured and evaluated with use of AccuPyc II 1340 manufactured by Shimadzu Corporation. With a He gas used as a probe, the temperature of the circulating thermostatic bath was set to 25°C. Purging with a He gas was performed 30 times as pretreatment of the samples; then, the measurement was repeated 10 times, and the mean value from these 10 measurements was used as the true density. The purge charging pressure and the measurement charging pressure of the He gas into the measurement cell were 135 kPa, and the purging was terminated when a change in pressure became 0.05 kPa/min.

30 g of each of the cerium oxides obtained in Examples 1 to 7 was changed into a receptacle containing 270 mL of pure water, irradiated by an ultrasonic homogenizer for 5 minutes, and subjected to disintegration and dispersion treatment. Next, zirconia balls of 5 mm$\varphi$ were added so that the resulting volume became approximately equal to the volume of the pure water, and the resultant was subjected to ball mill pulverization for 30 minutes and to disintegration and dispersion treatment. Next, jet milling treatment was performed 5 times for disintegration and dispersion treatment, and thus slurries in which the respective cerium oxides of Examples 1 to 8 were dispersed were obtained.

Herein, in the various disintegration and dispersion treatments, nitric acid was added, as appropriate, as a pH regulator to achieve a pH of 3-5. For the homogenizer, US-600TCVP (apparatus name) manufactured by NIHONSEIKI KAISHA LTD. was used, and for a wet-type jet mill, Star Burst Mini (apparatus name) manufactured by Sugino Machine Limited was used.

[Evaluation of Polishing Speed]

With the use of the slurries of Examples 1 to 7 obtained as described above, the polishing speed on silicon nitride was measured. For a polisher, a fully automatic CMP apparatus (manufactured by Applied Materials, Inc., apparatus name: Mirra) was used. For a polishing pad, a double-layer pad (manufactured by DuPont, product name: IC-1000 K-groove) was used, and conditioning was performed with use of a diamond disk (manufactured by 3M, product name: A165). Then, silicon nitride was polished for 1 minute with the feeding speed of the slurry serving as the polishing agent set to 200 cm$^3$/min, with the number of rotations of the polishing platen set to 77 rpm, and with the polishing pressure set to 3 psi.

The polishing speed was measured with use of an optical membrane thickness gauge (manufactured by KLA-Tencor, apparatus name: UV-1280SE). The evaluation was performed with the membrane thickness removal amount per minute regarded as the polishing rate (RR). With the polishing rate of Example 5 used as a reference (100), the polishing rate of each example was compared. The result is shown in Table 1.

[Table 1]

Table 1

| | Added Metal | Added Amount (mol%) | BET Diameter $d_B$ (nm) | BET Specific Surface Area (m²/g) | Scherrer Diameter $d_S$ (nm) | $d_B/d_S$ | Evaluation of Polishing Speed | | Density (g/cm³) |
|---|---|---|---|---|---|---|---|---|---|
| | | | | | | | SiN RR (Å/min) | SiN RR Improvement Rate (Example 5 being 100) | |
| Example 1 | La | 10 | 36.2 | 23.0 | 25.6 | 1.41 | 885 | 134 | 6.76 |
| Example 2 | Sr | 5 | 43.9 | 19.0 | 30.4 | 1.44 | 961 | 146 | 6.51 |
| Example 3 | Sr | 10 | 45.2 | 18.4 | 25.9 | 1.75 | 1130 | 171 | 6.41 |
| Example 4 | Ba | 10 | 57.7 | 14.4 | 24.4 | 2.36 | 1373 | 208 | 6.58 |
| Example 5 | None | - | 38.8 | 21.4 | 30.1 | 1.29 | 660 | 100 | 6.99 |
| Example 6 | Al | 10 | 20.2 | 41.1 | 15.0 | 1.35 | 704 | 107 | 6.81 |
| Example 7 | K | 1 | 106.0 | 7.9 | 69.5 | 1.53 | 663 | 100 | 7.21 |

As shown in Table 1, the cerium oxides of Examples 1 to 4, each having a BET diameter of no smaller than 15 nm nor greater than 100 nm, a Scherrer diameter of no smaller than 10 nm nor greater than 50 nm, and a value obtained by dividing the BET diameter by the Scherrer diameter of no smaller than 1.4 nor greater than 3.5, exhibit a high polishing speed on a silicon nitride film.

[Evaluation of Lattice Constant]

For each of the cerium oxides of Examples 1 to 7 obtained as described above, the lattice constant (a) was obtained through a pattern obtained in X-ray diffraction described above and the assigned Miller index (hkl). Then, a value ($\Delta$a) obtained by subtracting the lattice constant of the cerium oxide (Example 5) that does not contain metal from the lattice constant of the cerium oxides (Examples 1 to 4, 6, and 7) that each contain metal was calculated. These results are shown in Table 2.

Based on the results shown in Tables 1 and 2, the cerium oxides of Examples 1 to 4 each had a BET diameter of no smaller than 15 nm nor greater than 100 nm, a Scherrer diameter of no smaller than 10 nm nor greater than 50 nm, and $d_B/d_S$ of no smaller than 1.4 nor greater than 3.5, as a metal ion having an ionic radius greater than the ionic radius of a cerium ion was sufficiently incorporated into the lattice, and thus a high polishing speed on a silicon nitride film was obtained. Meanwhile, none of the cerium oxide of Example 5 in which no metal ion was added, the cerium oxide of Example 6 in which a metal ion having an ionic radius smaller than the ionic radius of a cerium ion was incorporated into the lattice, and the cerium oxide of Example 7 in which little metal ion was incorporated had a BET diameter, a Scherrer diameter, or $d_B/d_S$ within the ranges described above, and thus a high polishing speed on a silicon nitride film could not be obtained.

[Table 2]

Table 2

|  | a (Å) | $\Delta$a (Å) |
|---|---|---|
| Example 1 | 5.43705 | 0.02391 |
| Example 2 | 5.41843 | 0.00529 |
| Example 3 | 5.42177 | 0.00863 |
| Example 4 | 5.41812 | 0.00498 |
| Example 5 | 5.41314 | 0 |
| Example 6 | 5.40983 | -0.00310 |
| Example 7 | 5.41398 | 0.00084 |

**Industrial Applicability**

The cerium oxide according to the present invention has a high polishing speed not only on a silicon oxide film but also on a silicon nitride film. Therefore, in CMP of a surface to be polished in which a silicon oxide film and a silicon nitride film are arranged in a pattern, for example, the silicon oxide film and the silicon nitride film can be polished at the same speed or can be polished at a desired selection ratio, while maintaining a sufficient high polishing speed. Accordingly, the cerium oxide according to the present invention is suitable for flattening an STI insulating film in the manufacture of semiconductor devices.

This application claims priority to Japanese Patent Application No. 2020-148694, filed on September 4, 2020, the entire disclosure of which is incorporated herein.

**Reference Signs List**

1    SILICON SUBSTRATE
2    SILICON NITRIDE FILM
3    TRENCH

4  SILICON OXIDE FILM
5  TITANIUM NITRIDE FILM
20  POLISHING APPARATUS
21  SEMICONDUCTOR SUBSTRATE
22  POLISHING HEAD
23  POLISHING PLATEN
24  POLISHING PAD
25  POLISHING AGENT
26  POLISHING AGENT FEEDING PIPE

**Claims**

1. A cerium oxide having:

  a BET diameter of no smaller than 14 nm nor greater than 210 nm, the BET diameter being a particle size calculated from a specific surface area measured through a nitrogen gas adsorption method;
  a Scherrer diameter of no smaller than 10 nm nor greater than 60 nm, the Scherrer diameter being a crystallite diameter obtained through a powder X-ray diffraction method; and
  a value obtained by dividing the BET diameter by the Scherrer diameter of no smaller than 1.4 nor greater than 3.5.

2. A cerium oxide, wherein the cerium oxide is a particle having a true density of 5.0-6.8 $g/cm^3$.

3. The cerium oxide according to Claim 1 or 2, wherein the cerium oxide includes one or more metals selected from the group consisting of an alkaline-earth metal and a lanthanoid (excluding cerium).

4. The cerium oxide according to Claim 3, wherein the cerium oxide includes the metal in 1-20 mol%.

5. The cerium oxide according to Claim 3 or 4, wherein the lanthanoid includes lanthanum.

6. The cerium oxide according to any one of Claims 3 to 5,
  wherein the alkaline-earth metal includes one or more selected from the group consisting of barium and strontium.

7. The cerium oxide according to any one of Claims 3 to 6,
  wherein a value obtained by subtracting a lattice constant of a cerium oxide that does not include the metal from a lattice constant of a cerium oxide that includes the metal is 0.003-0.05 Å.

8. A polishing agent comprising:

  a cerium oxide; and
  water,
  wherein the cerium oxide has

  a BET diameter of no smaller than 14 nm nor greater than 210 nm, the BET diameter being a particle size calculated from a specific surface area measured through a nitrogen gas adsorption method,
  a Scherrer diameter of no smaller than 10 nm nor greater than 60 nm, the Scherrer diameter being a crystallite diameter obtained through a powder X-ray diffraction method, and
  a value obtained by dividing the BET diameter by the Scherrer diameter of no smaller than 1.4 nor greater than 3.5.

Fig. 1A

Fig. 1B

Fig. 2A

Fig. 2B

Fig. 3

## INTERNATIONAL SEARCH REPORT

| International application No. |
| --- |
| **PCT/JP2021/031821** |

**A. CLASSIFICATION OF SUBJECT MATTER**

*C09G 1/02*(2006.01)i; *C09K 3/14*(2006.01)i; *B24B 37/00*(2012.01)i; *H01L 21/304*(2006.01)i; *C01F 17/235*(2020.01)i
FI: C01F17/235; B24B37/00 H; C09K3/14 550D; C09G1/02; H01L21/304 622B

According to International Patent Classification (IPC) or to both national classification and IPC

**B. FIELDS SEARCHED**

Minimum documentation searched (classification system followed by classification symbols)

C09G1/02; C09K3/14; B24B37/00; H01L21/304; C01F17/235

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | WO 2009/031447 A1 (ASAHI GLASS COMPANY, LIMITED) 12 March 2009 (2009-03-12) claims, examples, etc. | 1-8 |
| X | WO 2007/126030 A1 (ASAHI GLASS COMPANY, LIMITED) 08 November 2007 (2007-11-08) claims, examples, etc. | 1, 3-8 |
| A | JP 2007-84755 A (HITACHI MAXELL LTD) 05 April 2007 (2007-04-05) claims, examples, etc. | 1, 8 |
| A | JP 2020-23408 A (JGC CATALYSTS & CHEMICALS LTD) 13 February 2020 (2020-02-13) claims, examples, etc. | 1, 8 |
| A | JP 2003-206475 A (HITACHI MAXELL LTD) 22 July 2003 (2003-07-22) claims, examples, etc. | 1, 8 |
| A | JP 2012-38361 A (SHOWA DENKO KK) 23 February 2012 (2012-02-23) claims, examples, etc. | 1-8 |

☐ Further documents are listed in the continuation of Box C.　　☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **26 October 2021** | **16 November 2021** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
**Information on patent family members**

International application No.

**PCT/JP2021/031821**

| Patent document cited in search report | | | Publication date (day/month/year) | Patent family member(s) | | | Publication date (day/month/year) |
|---|---|---|---|---|---|---|---|
| WO | 2009/031447 | A1 | 12 March 2009 | US | 2010/0159246 | A1 | |
| | | | | claims, examples | | | |
| | | | | CN | 101784486 | A | |
| | | | | KR | 10-2010-0062998 | A | |
| WO | 2007/126030 | A1 | 08 November 2007 | US | 2009/0113809 | A1 | |
| | | | | claims, examples | | | |
| | | | | EP | 2011765 | A1 | |
| JP | 2007-84755 | A | 05 April 2007 | (Family: none) | | | |
| JP | 2020-23408 | A | 13 February 2020 | (Family: none) | | | |
| JP | 2003-206475 | A | 22 July 2003 | US | 2004/0244675 | A1 | |
| | | | | claims, examples | | | |
| | | | | GB | 2396157 | A | |
| | | | | WO | 2003/014251 | A1 | |
| JP | 2012-38361 | A | 23 February 2012 | (Family: none) | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019087660 A
- JP 2017529296 A

- JP 2020148694 A

**Non-patent literature cited in the description**

- **BRUNAUER, S. ; EMMETT, P. T. ; TELLER, E.** Adsorption Gases in Multimolecular Layers. *J. Amer. Che. Soc.,* 1938, vol. 60 (2), 309-319